(19) Europäisches Patentamt

**European Patent Office**

**Office européen des brevets**

(11) Veröffentlichungsnummer: **0 283 907 B1**

(12) **EUROPÄISCHE PATENTSCHRIFT**

(45) Veröffentlichungstag der Patentschrift: **15.01.92**

(51) Int. Cl.⁵: **G11C 29/00**

(21) Anmeldenummer: **88104112.3**

(22) Anmeldetag: **15.03.88**

(54) Schaltungsanordnung und Verfahren zum Testen von Speicherzellen.

(30) Priorität: **16.03.87 DE 3708534**

(43) Veröffentlichungstag der Anmeldung:
**28.09.88 Patentblatt 88/39**

(45) Bekanntmachung des Hinweises auf die
Patenterteilung:
**15.01.92 Patentblatt 92/03**

(84) Benannte Vertragsstaaten:
**AT DE FR GB IT NL**

(56) Entgegenhaltungen:
**EP-A- 0 143 624**
**DE-A- 3 530 591**
**US-A- 4 055 754**

**PATENT ABSTRACTS OF JAPAN, Band 6, Nr.
188 (P-144)[1066], 28. September 1982; & JP-
A-57 100 690 (TOKYO SHIBAURA DENKI K.K.)
22-06-1982**

**PROCEEDINGS OF THE 1986 INTERNATIO-
NAL TEST CONFERENCE, Philadelphia, 8.-11.
September 1986, Seiten 830-839, IEEE; K.T.
LE et al.: "A novel approach for testing memories using a built-in self testing technique"**

(73) Patentinhaber: **SIEMENS AKTIENGESELL-
SCHAFT**
**Wittelsbacherplatz 2**
**W-8000 München 2(DE)**

(72) Erfinder: **Oberle, Hans-Dieter, Dipl.-Ing.**
**Edelweissstrasse 82**
**W-8039 Puchheim(DE)**
Erfinder: **Hoffmann, Kurt, Dr. Prof.**
**Nelkenweg 20**
**W-8028 Taufkirchen(DE)**
Erfinder: **Kowarik, Oskar, Dr. rer. nat.**
**Goethering 70**
**W-8018 Grafing(DE)**
Erfinder: **Kraus, Rainer, Dipl.-Phys.**
**Weidener Strasse 21**
**W-8000 München 83(DE)**

Rank Xerox (UK) Business Services

## Beschreibung

Die Erfindung betrifft eine Schaltungsanordnung zum Testen von Speicherzellen nach dem Oberbegriff des Patentanspruches 1 sowie ein Verfahren zum Testen von Speicherzellen nach dem Oberbegriff des Patentanspruches 8.

Die Zunahme der Anzahl von Speicherzellen in einem Halbleiterspeicher hat in den letzten Jahren zu einem enormen Anstieg der zum Testen eines Halbleiterspeichers notwendigen Testzeit geführt. Während beispielsweise ein DRAM mit 4kB Speicherkapazität seinerzeit in drei bis 20 s Prüfzeit (abhängig von Art und Anzahl der verwendeten Prüfmuster und sonstiger Prüfbedingungen) ausreichend prüfbar war, bewegt sich die Prüfzeit eines modernen 1MB-DRAM's in der Größenordnung von 20 min.

Es sind bereits verschiedene Maßnahmen zur Verkürzung der Prüfzeit bekannt: Die EP-A 0 186 040 schlägt beispielsweise vor, einen Halbleiterspeicher intern in mehrere Blöcke einzuteilen und diese parallel zueinander zu testen. Damit läßt sich in der Praxis die Testzeit auf etwa 1/4 bis 1/8 reduzieren.

Die US-PS 4,055,754 schlägt vor, jeweils alle Speicherzellen einer kompletten Wortleitung zeitlich parallel zueinander zu testen und dazu eine bestimmte Auswerteschaltung innerhalb des Halbleiterspeichers zu benützen. Diese Lösung ist, trotz großer Testzeitersparnis, insofern nachteilig, als eine Auswerteschaltung notwendig ist, die aus wenigstens drei logischen Gattern besteht, wovon zwei dieser Gatter eine Anzahl von Eingängen benötigen, die gleich der Anzahl der vorhandenen Wortleitungen ist. Eine Realisierung führt zu einem sehr großen zusätzlichen Flächenbedarf, was dem allgemeinen Drang hin zum Miniaturisieren von Schaltungen zuwiderläuft.

Aufgabe der vorliegenden Erfindung ist es deshalb, eine gattungsgemäße Schaltungsanordnung zu schaffen, die das Testen von Speicherzellen bei kürzestem Zeitaufwand und minimalem zusätzlichen Flächenbedarf ermöglicht. Es ist weiterhin Aufgabe der vorliegenden Erfindung, ein entsprechendes Verfahren zum Testen von Speicherzellen anzugeben. Es wird dabei in Kauf genommen, daß nicht alle denkbaren Prüfmuster getestet werden können. Ebenso wird in Kauf genommen, daß nicht alle möglichen Fehler und Fehlertypen erkannt werden können. Dies soll weiterhin einer ausführlichen Prüfung vorbehalten bleiben, die dann erst am Ende eines Produktionsablaufes erfolgen kann. Die Testvorgänge, die von der vorliegenden Erfindung mit kurzer Prüfdauer Gebrauch machen, sind hingegen als produktionsbegleitende Tests vorgesehen (um grobe Ausfälle möglichst früh erkennen zu können und damit Kosten sparen zu können) oder als kurze "Incoming Inspection"-Tests.

Diese Aufgabe wird gelöst durch die kennzeichnenden Merkmale der Patentansprüche 1 und 8. Vorteilhafte Aus- und Weiterbildungen sind in Unteransprüchen gekennzeichnet.

Die Erfindung wird anhand der Figuren näher erläutert:

Fig. 1    zeigt die erfindungsgemäße Schaltungsanordnung insgesamt,

Fig. 2    eine mögliche Ausgestaltung einer Diskriminatorschaltung.

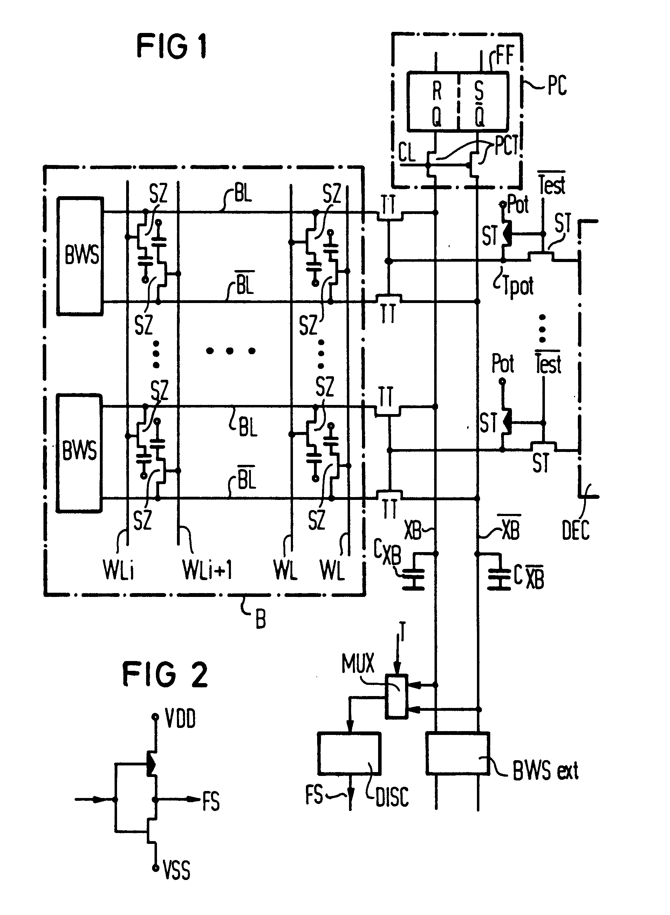

Fig. 1 zeigt einen Block B mit Speicherzellen SZ. Der zugehörige Halbleiterspeicher kann einen oder mehrere Blöcke B aufweisen. Dies ist Stand der Technik und aus Gründen der Übersichtlichkeit nicht dargestellt. Die Speicherzellen SZ sind matrixförmig angeordnet. Sie sind über Wortleitungen WLi,WLi + 1, allgemein WL, und über interne Bitleitungen adressierbar. Jeder internen Bitleitung ist, wie allgemein bekannt, eine Bewerterschaltung BWS zugeordnet.

Diese teilt die interne Bitleitung in zwei wenigstens annähernd gleiche Bitleitungshälften BL,$\overline{BL}$. Im allgemeinen sind die beiden Hälften aus Symmetriegründen im Hinblick auf die Funktionsweise der Bewerterschaltung BWS exakt gleich, soweit technologisch möglich.

Hinsichtlich der Anordnung von Bitleitungen und Bewerterschaltungen BWS sind dem Fachmann zwei verschiedene Konzepte bekannt. Beim älteren, sog. "Open-Bitline-Konzept" sind die beiden Bitleitungshälften beidseitig zu Bewerterschaltungen BWS angeordnet. Die Bewerterschaltungen BWS teilen also das Speicherzellenfeld eines Blokkes B in eine linke und eine rechte Zellenfeldhälfte. Beim moderneren Bitleitungskonzept, "Folded-Bitline-Konzept" genannt, sind beide Bitleitungshälften auf einer einzigen Seite der Bewerterschaltung BWS angeordnet. Die Bewerterschaltungen BWS sind bei diesem Konzept also am Rande des Zellenfeldes zu finden. Die vorliegende Erfindung ist bei beiden Bitleitungskonzepten realisierbar.

Auch die Bewerterschaltungen und die Speicherzellen sind Stand der Technik. Der Fachwelt bekannte Bewerterschaltungen enthalten zwei über ihre Gates kreuzgekoppelte Transistoren mit einem gemeinsamen Anschluß an ein meist schaltbares oder in seinem zeitlichen Verlauf steuerbares Potential. Die freien Enden der Transistoren der Bewerterschaltungen sind jeweils mit einer Bitleitungshälfte BL,$\overline{BL}$ verbunden. Andere Ausgestaltungen nach dem Stand der Technik sind denkbar.

Auch die Speicherzellen sind nach dem Stand der Technik gestaltet. Bei einem DRAM als Halbleiterspeicher sind es im allgemeinen 1-Transistorspeicherzellen. Auf statische Speicher (SRAM's) und auf programmierbare Speicher wie EPROM's und EEPROM's ist die vorliegende Erfindung ebenfalls ohne wesentliche Änderung anwendbar. Im vorliegenden Fall sind 1-Transistorspeicherzellen eines DRAM's dargestellt. Ob die Speicherkonzeption so angelegt ist, daß sog. Dummyzellen vorzusehen sind, oder ob die Bewerterschaltung nach dem sog. Mid-Level-Konzept arbeitet, ist für die Anwendung der Erfindung ebenfalls ohne Belang.

Die erfindungsgemäße Schaltungsanordnung enthält weiterhin je Block B ein Paar externer Bitleitungen XB,$\overline{XB}$. Diese sind beispielsweise an ihrem einen Ende (jede beliebige andere Position ist auch denkbar) mit einer Vorladeeinrichtung PC verbunden. Sie dient dem Vorladen der externen Bitleitungen XB,$\overline{XB}$ auf zwei zueinander komplementäre logische Pegel, insbesondere auf das Versorgungspotential VCC und das Bezugspotential VSS des Halbleiterspeichers, was noch beschrieben wird. Das Paar von externen Bitleitungen XB,$\overline{XB}$ ist weiterhin, wie allgemein üblich, mit einer externen Bewerterschaltung BWSext verbunden. Außerdem ist es mit einer Diskriminatorschaltung DISC verbunden. Der Ausgang der Diskriminatorschaltung DISC dient der Anzeige eines aufgetretenen Fehlers im Testfall durch ein Fehlersignal FS.

Jede erste Bitleitungshälfte BL einer internen Bitleitung ist über einen Transfertransistor TT mit der ersten der externen Bitleitungen (XB) verbunden. Entsprechend ist jede zweite Bitleitungshälfte $\overline{BL}$ einer internen Bitleitung ebenfalls über einen Transfertransistor TT mit der zweiten der externen Bitleitungen ($\overline{XB}$) verbunden. Beide Transfertransistoren TT einer Bitleitung bilden somit ein Transfertransistorpaar. Das Gate jedes Transfertransistors TT ist vorteilhafterweise über den n-Kanal-Transistor eines CMOS-Schalttransistorpaares ST mit einem der jeweiligen internen Bitleitung entsprechenden Bitleitungsdecoder (symbolisch angedeutet mit "DEC") verbunden. Außerdem ist dieses Gate erfindungsgemäß über den p-Kanal-Transistor des CMOS-Schalttransistorenpaares ST mit einem Potential Pot verbunden. Das Potential Pot kann beispielsweise das Versorgungspotential VCC des gesamten Halbleiterspeichers sein. Es kann in einer anderen Ausführungsform der Erfindung jedoch auch einen Wert aufweisen, der mindestens die Hälfte der Differenz aus Versorgungspotential VCC und Bezugspotential VSS der gesamten Schaltungsanordnung beträgt. Die Gates des CMOS-Schalttransistorpaares ST sind mit einem Signal $\overline{Test}$ verbunden. Im Testfall wird, durch das Signal $\overline{Test}$ gesteuert, das Potential Pot durch den p-Kanal-Transistor als Transferpotential Tpot an die Gates der Transistorpaare TT angelegt. Es ersetzt somit die im Normalbetrieb üblichen Decoderausgangssignale. Während also im Normalbetrieb die internen Bitleitungen BL,$\overline{BL}$ wie üblich einzeln über Bitleitungsdecoder angesteuert werden (in Fig. 1 schematisch mit "DEC" angedeutet), werden bei der vorliegenden Erfindung im Testbetrieb alle internen Bitleitungen BL,$\overline{BL}$ parallel zueinander angesteuert, was über die CMOS-Schalttransistorpaare ST geschehen kann. Es sind auch Lösungen denkbar, bei denen diese Ansteuerungen in den Decodern DEC enthalten sind, so daß beispielsweise alle Decoder gleichzeitig aktiviert werden. In diesem Zusammenhang wird ausdrücklich auf folgende Schutzrechte gleichen Zeitranges wie die vorliegende Erfindung verwiesen: EP-A-0 282 975 und EP-A-0 283 908.

Die Diskriminatorschaltung DISC ist vorteilhafterweise eine einfache, allseits bekannte CMOS-Inverterschaltung, wie in Fig. 2 gezeigt. Ihr Eingang ist, beispielsweise über einen Multiplexer MUX an beide externe Bitleitungen XB,$\overline{XB}$ angeschlossen: Ein Steuersignal T schaltet denjenigen Eingang des Multiplexers MUX auf die Diskriminatorsohaltung DISC durch, der mit derjenigen der externen Bitleitungen XB, $\overline{XB}$ verbunden ist, die zuvor auf log. 1 vorgeladen wurde. Es ist besonders vorteilhaft, den p-Kanal-Transistor so auszugestalten, daß seine Kanalweite 10 bis 20 mal so groß ist wie diejenige des n-Kanal-Transistors bei angenommener gleicher Kanallänge. Damit ist die Diskriminatorschaltung DISC in dem Potentialbereich, den eine der beiden externen Bitleitungen XB,$\overline{XB}$ im Fehlerfall annimmt, besonders empfindlich.

In einer Ausführungsform der Erfindung weist die Vorladeeinrichtung PC eine RS-Flip-Flop-Schaltung FF auf mit zwei üblichen, zueinander komplementären Ausgängen Q,$\overline{Q}$. Jeder Ausgang Q,$\overline{Q}$ ist über einen Precharge-Transistor PCT mit dem Paar von externen Bitleitungen XB,$\overline{XB}$ verbunden. Die Gates der Precharge-Transistoren PCT sind mit einem Clocksignal CL verbunden. Dieses steuert im Testfall das Vorladen der externen Bitleitungen XB,$\overline{XB}$ durch die Vorladeeinrichtung PC.

Anhand der geschilderten vorteilhaften Schaltungsanordnung lassen sich nun deren Arbeitsweise sowie das erfindungsgemäße Verfahren schildern:

Im Testfall werden je Wortleitung WL alle mit dieser Wortleitung WL verbundenen Speicherzellen SZ auf einen logischen Pegel aufgeladen, der für alle mit der Wortleitung WL verbundenen Speicherzellen SZ gleich ist. Der logische Pegel steht stellvertretend für eine in die Speicherzellen SZ einzuschreibende Information. Der logische Pegel kann durchaus unterschiedlich sein (log. 0 oder log. 1) bei den einzelnen Wortleitungen. Es ist nur wichtig, daß innerhalb einer Wortleitung alle Speicherzellen mit der gleichen Information beschrieben werden.

Damit ist die Auswahl der möglichen anzuwendenden Prüfmuster auf solche Prüfmuster beschränkt, bei denen alle Speicherzellen einer Wortleitung die gleiche Information enthalten. Solche Prüfmuster sind z.B. "All 0's", "All 1's", "Alternating Rows", linke Hälfte des Speicherzellenfeldes "All 0's" und rechte Hälfte "All 1's" oder umgekehrt. Nicht möglich ist beispielsweise das Prüfmuster "Checkerboard", bei dem bekanntlich die in den Speicherzellen einer Wortleitung gespeicherte Information von Speicherzelle zu Speicherzelle alterniert ('1010'). Blendet man jedoch durch geeignete Maßnahmen an den Bitleitungsdekodern die Speicherzellen einzelner Bitleitungen von der Prüfung aus, so sind auch kompliziertere Prüfungsmuster wie z.B. das obengenannte Prüfmuster Checkerboard möglich. Für einfache Funktionstests wie Incoming Inspection oder Grobprüfung daraufhin, ob der Speicher überhaupt funktionsfähig ist, ist dies jedoch völlig ausreichend. Wenn man die Speicherzellen jeder Wortleitung sowohl auf "Information gleich log. 0" als auch auf "Information gleich log. 1" prüft, lassen sich mit dem erfindungsgemäßen Verfahren folgende Fehler in jedem Fall finden:

    a) Bitleitung ist auf ein (beliebiges) Potential "festgeklemmt";

    b) (wenigstens) eine Speicherzelle ist auf ein (beliebiges) Potential "festgeklemmt".

    Die beiden nachfolgenden Fehlertypen lassen sich in den meisten Fällen feststellen:

    c) (Wenigstens) ein Wortleitungsdecoder arbeitet fehlerhaft;

    d) (wenigstens) eine Wortleitung ist auf ein (beliebiges) Potential "festgeklemmt".

    Die notwendige Testzeit ist nicht, wie üblich, bestimmt u.a. durch die Anzahl der (zu prüfenden) Speicherzellen SZ, sondern durch die Anzahl der Wortleitungen WL.

    Entweder gleichzeitig mit dem Beschreiben der Speicherzellen SZ oder anschließend daran, jedoch vor dem Auslesen aus den Speicherzellen SZ einer Wortleitung WL, wird das externe Bitleitungspaar $XB,\overline{XB}$ auf zwei zueinander komplementäre logische Pegel aufgeladen (log. 0, log. 1). Diese logischen Pegel sind von ihrer Bedeutung her gleich den logischen Pegeln, die in die Speicherzellen als Informationen einschreibbar sind. Die Zuordnung der logischen Pegel zu den beiden Leitungen des externen Bitleitungspaares $XB,\overline{XB}$ wird so getroffen, allgemein ausgedrückt, daß für diejenige der externen Bitleitungen $XB,\overline{XB}$ die über Transfertransistoren TT mit solchen internen Bitleitungshälften $BL,\overline{BL}$ verbunden ist, deren zugehörige Speicherzellen zu testen sind, der logische Pegel gleich ist dem logischen Pegel, den diese Speicherzellen SZ als Information in Form gespeicherter Ladungen aufweisen.

    Im konkreten Fall, auf die erfindungsgemäße Schaltungsanordnung nach Fig. 1 bezogen, bedeutet dies: Es sei angenommen, daß (im nächsten Testzyklus) alle die mit der Wortleitung WLi verbundenen Speicherzellen SZ getestet werden sollen. In diesen Speicherzellen SZ sei eine log. 1 als Information in Form von elektrischen Ladungen gespeichert. Diese Speicherzellen SZ sind alle mit den ersten Bitleitungshälften BL ihrer ihnen zugeordneten Bitleitungen verbunden. Jede dieser ersten Bitleitungshälften BL der internen Bitleitungen ist über einen Transfertransistor TT mit der einen externen Bitleitung XB verbunden. Da nun die zu testenden Speicherzellen SZ angenommenermaßen eine log. 1 gespeichert haben sollen, ist die eine externe Bitleitung XB ebenfalls auf eine log. 1 vorzuladen. Entsprechend ist die andere externe Bitleitung $\overline{XB}$ komplementär dazu auf eine log. 0 vorzuladen. Sollen im Gegensatz dazu die zu testenden Speicherzellen SZ eine log. 0 gespeichert haben, so sind die eine externe Bitleitung XB auf log. 0 vorzuladen und die andere externe Bitleitung $\overline{XB}$ auf log. 1. Die Fälle, in denen die zu testenden Speicherzellen SZ mit den zweiten internen Bitleitungshälften $\overline{BL}$ verbunden sind, sind vom Fachmann anhand des oben gesagten leicht selbst nachvollziehbar.

    Das Vorladen selbst erfolgt durch die Vorladeeinrichtung PC. In dem Falle, in dem die Vorladeeinrichtung PC ein RS-Flip-Flop FF aufweist, wird dieses beispielsweise gesetzt, so daß sein der einen externen Bitleitung XB zugeordneter Ausgang Q eine log. 1 aufweist und sein der anderen externen Bitleitung $\overline{XB}$ zugeordneter Ausgang $\overline{Q}$ eine log. 0 aufweist. Der Vorladevorgang selbst wird bei dieser Ausführungsform mittels der Precharge-Transistoren PCT durchgeführt. Dazu werden, wie bereits erwähnt, während oder nach dem Einschreiben der Informationen in die Speicherzellen SZ, über ein Clocksignal CL gesteuert, die Precharge-Transistoren PCT leitend geschaltet und anschließend wieder gesperrt. Die Ladungen in den externen Bitleitungen $XB,\overline{XB}$ bleiben nun in deren parasitären Kapazitäten $C_{XB}$, $C_{\overline{XB}}$ gespeichert.

    Daraufhin wird, gesteuert durch in Fig. 1 nicht dargestellte Wortleitungsdecoder, die nach dem Stand der Technik sein können, genau eine Wortleitung, im Beispiel die Wortleitung WLi, aktiviert. Somit gelangt bei allen mit dieser Wortleitung WLi verbundenen Speicherzellen SZ die gespeicherte Information auf die der jeweiligen Speicherzelle zugeordnete Bitleitungshälfte, im Beispiel speziell auf die erste Bitleitungshälfte BL. Nun werden auf bekannte Art und Weise die elektrischen Zustände jeder Bitleitung durch die ihr zugeordnete Bewerterschaltung BWS bewertet und verstärkt. Dadurch bilden sich auf den beiden Bitleitungshälften $BL,\overline{BL}$ jeder Bitleitung die log. Zustände 0 und 1 mit elektrisch deutlich voneinander unterscheidbaren Pegeln aus.

    Im vorliegenden Biespiel wurde angenommen, daß eine log. 1 aus den Speicherzellen SZ auszulesen sei. Sind nun alle ausgelesenen Speicherzellen SZ in Ordnung, so ist auf jeder ersten Bitleitungshälfte BL eine log. 1 und auf jeder zweiten Bitleitungshälfte $\overline{BL}$ eine log. 0. An den Gates aller Transfertransistoren TT liegt das Transferpotential Tpot. Demzufolge sperren alle Transfertransistoren TT, die mit den ersten Hälften der internen Bitleitungen BL verbunden sind (Potential Tpot an den Gates ist (bei angenommener n-Kanal-Technologie bzw. CMOS-Technologie bezüglich der Trenntransistoren TT) kleiner oder maximal gleich den Potentialen auf den ersten Bitleitungshälften BL der internen Bitleitungen und der einen externen Bitleitung XB); das auf der einen externen Bitleitung XB vorgeladene Potential bleibt im wesentlichen erhalten. Die mit den zweiten Hälften $\overline{BL}$ der internen Bitleitungen verbundenen Transfertransistoren TT leiten. Da die zweiten Hälften $\overline{BL}$ der internen Bitleitungen aufgrund des vorangegangenen Auslese- und Verstärkungsvorganges bezüglich der mit der Wortleitung WLi verbundenen Speicherzellen SZ eine log. 0 aufweisen, wird diese auf die andere externe Bitleitung $\overline{XB}$ durchgeschaltet. Diese ist bekanntlich bereits auf log. 0 vorgeladen. Am Zustand der externen Bitleitungen XB,$\overline{XB}$ ändert sich somit nichts.

Der Eingang der Diskriminatorschaltung DISC ist, beispielsweise über eine Multiplexschaltung MUX, mit derjenigen der externen Bitleitungen XB,$\overline{XB}$ verbunden, die ursprünglich auf log. 1 vorgeladen wurde. Im angenommenen Beispiel, in dem eine log. 1 aus den Speicherzellen SZ der Wortleitung WLi auszulesen war und alle diese zu testenden Speicherzellen SZ in Ordnung sind (Gut-Fall), bleibt die log. 1 auf der einen externen Bitleitung XB erhalten. Dies erkennt die Diskriminatorschaltung DISC, ihr Ausgangssignal, das das Fehlersignal FS ist, bleibt auf log. 0, was "gut" bedeuten soll.

Wenn jedoch ein Fehler auftritt, so leitet der Transfertransistor TT derjenigen ersten Bitleitungshälfte BL der internen Bitleitungen BL,$\overline{BL}$, die mit dem Fehler behaftet ist. In diesem Fall weist die fehlerbehaftete erste Bitleitungshälfte BL eine log. 0 auf; der zugehörige Transfertransistor TT schaltet die log. 0 auf die eine externe Bitleitung XB durch. Die externe Bitleitung XB wird dadurch potentialmäßig in Richtung "log. 0" gezogen. Dies geschieht solange, bis die Transfertransistoren TT derjenigen ersten Bitleitungshälften BL zu leiten beginnen, die kein fehlerhaftes Verhalten aufweisen. Es stellt sich ein Gleichgewicht ein bei etwa Tpot - $V_{th}$ ($V_{th}$: Schwellspannung der Transfertransistoren TT). Die Diskriminatorschaltung erkennt dies und setzt ihr Ausgangssignal als Fehlersignal FS auf log. 1. Durch die Wahl von Tpot kleiner als das Versorgungspotential VCC wird erreicht, daß im Fehlerfall der Potentialabstand der ursprünglich auf log. 1 vorgeladenen externen Bitleitung XB

(bzw. $\overline{XB}$) größer ist als die Schwellspannung $V_{th}$ eines Transfertransistors TT.

In dem Fall, in dem die zu testenden Speicherzellen SZ eine log. 0 enthalten sollen, wird der Effekt ausgenützt, daß sich bei jeder internen Bitleitung auf derjenigen Bitleitungshälfte ($\overline{BL}$ nach dem bisherigen Biespiel), die nicht mit der zu testenden jeweiligen Speicherzelle verbunden ist, ein zum ausgelesenen und verstärkten Lesesignal komplementäres Signal, d.h. also im Gut-Fall eine log. 1 ausbildet. Die eine externe Bitleitung XB ist auf log. 0 vorgeladen, die andere externe Bitleitung $\overline{XB}$ auf log. 1. Anhand der obenstehenden Ausführungen, einen Test auf log. 1 betreffend, kann nur der Fachmann selbst nachvollziehen, daß im Gut-Fall die andere externe Bitleitung $\overline{XB}$ ihren Wert log. 1 beibehält und demzufolge die Diskriminatorschaltung DISC das Fehlersignal FS nicht aktiviert und daß im Fehlerfall die andere externe Bitleitung $\overline{XB}$ potentialmäßig in Richtung log. 0 gezogen wird, was die Diskriminatorschaltung DISC erkennt und entsprechend ihr Fehlersignal aktiviert. Von einer ausführlichen Erläuterung wird deshalb abgesehen.

Es ist vorteilhaft, daß die Diskriminatorschaltung DISC entweder einschließlich der Multiplexschaltung MUX oder durch die Multiplexschaltung MUX von den externen Bitleitungen XB,$\overline{XB}$ entkoppelbar ist, so daß dieser Schaltungszweig im Normalbetrieb keine zusätzliche Belastung für die externen Bitleitungen XB,$\overline{XB}$ darstellt.

Hinsichtlich der Erzeugung von speziellen Test- und Steuersignalen wird insbesondere auf das im Zeitrang gleiche Schutzrecht EP-A-0 282 976 und EP-A-0 286 852 hingewiesen. Bezüglich spezieller Dekoderausgestaltungen wird auf die im Zeitrang gleichen Schutzrechte EP-A-0 282 975 und EP-A-0 283 908 hingewiesen.

**Patentansprüche**

1. Schaltungsanordnung zum Prüfen von matrixförmig angeordneten Speicherzellen (SZ) eines Blockes (B) eines integrierten Halbleiterspeichers, die über Wort- und interne Bitleitungen ansteuerbar sind, bei der jeder internen Bitleitung (BL,$\overline{BL}$) eine Bewerterschaltung (BWS) zugeordnet ist, die die interne Bitleitung in zwei wenigstens annähernd gleiche Bitleitungshälften teilt und mit einem Paar externer Bitleitungen (XB,$\overline{XB}$), wobei die eine externe Bitleitung mit der einen Hälfte jeder internen Bitleitung verbunden ist und die andere externe Bitleitung mit der anderen Hälfte jeder internen Bitleitung, wobei diese Verbindungen über Transfertransistoren (TT) erfolgen, die gatemäßig jeweils mit einem der jeweiligen internen Bitleitungen zugeordneten Bitleitungsdecoder verbunden sind, **dadurch gekennzeichnet,**

daß das Paar externer Bitleitungen (XB,$\overline{XB}$) mit einer Vorladeeinrichtung (PC) und mit einer Diskriminatorschaltung (DISC) verbunden ist, daß die Vorladeeinrichtung (PC) im Testbetrieb einem Vorladen des externen Bitleitungspaares (XB,$\overline{XB}$) auf zwei zueinander komplementäre logische Pegel dient, daß die Diskriminatorschaltung (DISC) an ihrem Ausgang ein Fehlersignal (FS) aufweist, das im Testbetrieb das Auftreten von Fehlern anzeigt, wobei die Diskriminatorschaltung (DISC) ein Abweichen des Pegels einer externen Bitleitung (XB;$\overline{XB}$) des Paares externer Bitleitungen (XB,$\overline{XB}$) von dem logischen Pegel, auf dem sie vorgeladen ist, als Fehler erkennt und daß im Testbetrieb zum Auslesen von Daten aus den Speicherzellen (SZ) des Blockes (B) alle Transfertransistoren (TT) gatemäßig ein Transferpotential (Tpot) aufweisen.

2. Schaltungsanordnung nach Anspruch 1, **dadurch gekennzeichnet,** daß das Transferpotential (Tpot) gleich dem Versorgungspotential (VCC) der gesamten Schaltungsanordnung ist.

3. Schaltungsanordnung nach Anspruch 1, **dadurch gekennzeichnet,** daß das Transferpotential (Tpot) mindestens die Hälfte der Differenz zwischen dem Versorgungspotential (VCC) und dem Bezugspotential (VSS) der gesamten Schaltungsanordnung beträgt.

4. Schaltungsanordnung nach einem der vorhergehenden Ansprüche, **dadurch gekennzeichnet**, daß die Vorladeeinrichtung (PC) eine RS-Flipflop-Schaltung (FF) aufweist mit zwei zueinander komplementären Ausgängen (Q$\overline{Q}$) und daß die Ausgänge (Q,$\overline{Q}$) über Precharge-Transistoren (PCT) mit dem Paar der externen Bitleitungen (XB,$\overline{XB}$) verbunden sind.

5. Schaltungsanordnung nach einem der vorhergehenden Ansprüche, **dadurch gekennzeichnet**, daß die Diskriminatorschaltung (DISC) eine CMOS-Inverterschaltung ist, deren Eingang zwischen den beiden externen Bitleitungen (XB,$\overline{XB}$) umschaltbar ist.

6. Schaltungsanordnung nach Anspruch 5, **dadurch gekennzeichnet**, daß die Kanalweite des p-Kanal-Transistors der CMOS-Inverterschaltung 10 bis 20 mal so groß ist wie diejenige des n-Kanal-Transistors bei angenommener gleicher Kanallänge.

7. Schaltungsanordnung nach einem der vorhergehenden Ansprüche, **dadurch gekennzeichnet**, daß die Diskriminatorschaltung (DISC) von dem Paar externer Bitleitungen (XB,$\overline{XB}$) elektrisch entkoppelbar ist.

8. Verfahren zum Testen von Speicherzellen (SZ) eines Blockes (B) eines Halbleiterspeichers, die matrixförmig angeordnet sind, die über Wortleitungen (WL) und interne Bitleitung (BL,$\overline{BL}$) ansteuerbar sind, deren interne Bitleitungen jeweils über eine Bewerterschaltung (BWS) in zwei annähernd gleiche Hälften aufgeteilt sind, wobei die erste Hälfte jeder internen Bitleitung mit einer ersten externen Bitleitung eines externen Bitleitungspaares über einen Transfertransistor (TT) verbunden ist und wobei die zweite Hälfte jeder internen Bitleitung mit einer zweiten externen Bitleitung des externen Bitleitungspaares ebenfalls über einen Transfertransistor verbunden ist, **dadurch gekennzeichnet,** daß das Testen mittels der beiden externen Bitleitungen (XB,$\overline{XB}$) für mehr als eine bis maximal alle mit einer Wortleitung (WL) verbundenen Speicherzellen (SZ) unter Verwendung einer mit dem Paar externer Bitleitungen (XB,$\overline{XB}$) verbundenen Diskriminatorschaltung (DISC) gleichzeitig erfolgt, daß die Bitleitungen des Paares externer Bitleitungen (XB,$\overline{XB}$) auf zwei zueinander komplementäre logische Pegel vorgeladen werden, daß an die Gates der Transfertransistoren (TT) ein Transferpotential (Tpot) angelegt wird, daß die Diskriminatorschaltung (DISC) beim Lesen von in den Speicherzellen (SZ) gespeicherten Daten ein Abweichen des Pegels einer externen Bitleitung (XB;$\overline{XB}$) des Paares externer Bitleitungen (XB,$\overline{XB}$) als Fehler erkennt und daß bei Auftreten eines solchen Fehlers am Ausgang der Diskriminatorschaltung (DISC) ein Fehlersignal (FS) aktiviert wird.

9. Verfahren nach Anspruch 8, **dadurch gekennzeichnet,** daß im Testfall vor dem Auslesen von Daten aus Speicherzellen die beiden externen Bitleitungen (XB,$\overline{XB}$) auf zueinander komplementäre logische Pegel, insbesondere auf das Versorgungspotential (VCC) und das Bezugspotential (VSS) der Schaltungsanordnung aufgeladen werden.

10. Verfahren nach Anspruch 8 oder 9, **dadurch gekennzeichnet,** daß das Fehlersignal (FS) dann gesetzt wird, wenn diejenige der beiden externen Bitleitungen (XB,$\overline{XB}$), die auf den höheren Pegel, vorzugsweise auf das Versorgungspotential (VCC) vorgeladen ist, pegelmäßig auf wenigstens einen Wert absinkt, der der Höhe eines Transferpotentials (Tpot) abzüglich einer Schwellspannung der Transfertransistoren (TT) entspricht.

**Claims**

1. Circuit arrangement for testing memory cells (SZ), arranged in a matrix shape, of a block (B) of an integrated semiconductor memory which can be driven by means of word lines and internal bit lines, in which each internal bit line (BL, $\overline{BL}$) is assigned an evaluator circuit (BWS) which divides the internal bit line into two at least approximately identical bit line halves and having a pair of external bit lines (XB, $\overline{XB}$), the one external bit line being connected to the one half of each internal bit line and the other external bit line to the other half of each internal bit line, these connections being made via transfer transistors (TT) which are connected at their gates in each case to a bit line decoder assigned to the respective internal bit lines, characterised in that the pair of external bit lines (XB, $\overline{XB}$) is connected to a precharger device (PC) and to a discriminator circuit (DISC), in that the precharger device (PC) serves in test mode for precharging the external bit line pair (XB, $\overline{XB}$) to two logical levels which are complementary to one another, in that the discriminator circuit (DISC) has at its output a fault signal (FS) which in test mode indicates the occurrence of faults, the discriminator circuit (DISC) detecting a deviation of the level of an external bit line (XB; $\overline{XB}$) of the pair of external bit lines (XB, $\overline{XB}$) from the logical level to which it is precharged as a fault, and in that in test mode all the transfer transistors (TT) have at their gates a transfer potential (Tpot) for reading out data from of the memory cells (SZ) of the block (B).

2. Circuit arrangement according to Claim 1, characterised in that the transfer potential (Tpot) is equal to the supply potential (VCC) of the entire circuit arrangement.

3. Circuit arrangement according to Claim 1, characterised in that the transfer potential (Tpot) is at least half the difference between the supply potential (VCC) and the reference potential (VSS) of the entire circuit arrangement.

4. Circuit arrangement according to one of the preceding claims, characterised in that the precharger device (PC) has an RS flip-flop circuit (FF) with two outputs (Q, $\overline{Q}$) which are complementary to one another and in that the outputs (Q, $\overline{Q}$) are connected via precharge transistors (PCT) to the pair of external bit lines (XB, XB).

5. Circuit arrangement according to one of the preceding claims, characterised in that the discriminator circuit (DISC) is a CMOS inverter circuit whose input can be switched between the two external bit lines (XB, $\overline{XB}$).

6. Circuit arrangement according to Claim 5, characterised in that channel width of the p-type channel transistor of the CMOS inverter circuit is 10 to 20 times greater than that of the n-type channel transistor assuming identical channel length.

7. Circuit arrangement according to one of the preceding claims, characterised in that the discriminator circuit (DISC) can be electrically isolated from the pair of external bit lines (XB, $\overline{XB}$).

8. Method for testing memory cells (SZ) of a block (B) of a semiconductor memory which cells are arranged in a matrix shape and can be driven by means of word lines (WL) and internal bit lines (BL, $\overline{BL}$), the internal bit lines of which are divided up into two approximately identical halves in each case by means of an evaluator circuit (BWS), the first half of each internal bit line being connected to a first external bit line of an external bit line pair via a transfer transistor (TT) and the second half of each internal bit line being connected to a second external bit line of the external bit line pair also via a transfer transistor, characterised in that the testing by means of the two external bit lines (XB, $\overline{XB}$) occurs simultaneously for more than one to a maximum of all the memory cells (SZ) connected to a word line (WL) using a discriminator circuit (DISC) connected to the pair of external bit lines (XB, $\overline{XB}$), in that the bit lines of the pair of external bit lines (XB, $\overline{XB}$) are precharged to two logical levels which are complementary to one another, in that a transfer potential (Tpot) is applied to the gates of the transfer transistors (TT), in that the discriminator circuit (DISC) detects during the reading of data stored in the memory cells (SZ) a deviation of the level of an external bit line (XB; $\overline{XB}$) of the pair of external bit lines (XB, $\overline{XB}$) as a fault, and in that on the occurrence of such a fault a fault signal (FS) is activated at the output of the discriminator circuit (DISC).

9. Method according to Claim 8, characterised in that in the event of testing, before reading out data from memory cells the two external bit lines (XB, $\overline{XB}$) are precharged to logical levels which are complementary to one another, in particular to the supply potential (VCC) and the reference potential (VSS) of the circuit arrangement.

10. Method according to Claim 8 or 9, characterised in that the fault signal (FS) is set when that bit line of the two external bit lines (XB, $\overline{XB}$) which is precharged to the higher level, preferably to the supply potential (VCC), drops in terms of level to at least a value which corresponds to the level of a transfer potential (Tpot) minus a threshold voltage of the transfer transistors (TT).

**Revendications**

1. Montage pour tester des cellules de mémoire (SZ), disposées sous la forme d'une matrice, d'un bloc (B) d'une mémoire intégrée à semiconducteurs, qui peuvent être commandées par l'intermédiaire de lignes de transmission de mots et de lignes internes de transmission de bits, et dans laquelle à chaque ligne interne de transmission de bits (BL,$\overline{BL}$) est associé un circuit d'évaluation (BWS) qui subdivise la ligne interne de transmission de bits en deux moitiés au moins approximativement identiques, et comportant un couple de lignes externes de transmission de bits (XB,$\overline{XB}$), et dans lequel une ligne externe de transmission de bits est raccordée à une moitié de chaque ligne interne de transmission de bits et l'autre ligne externe de transmission de bits est raccordée à l'autre moitié de chaque ligne interne de transmission de bits, ces liaisons étant réalisées par l'intermédiaire de transistors de transfert (TT) dont les grilles sont raccordées respectivement à un décodeur des lignes de transmission de bits, associé aux lignes respectives de transmission de bits, caractérisé par le fait que le couple de lignes externes de transmission de bits (XB,$\overline{XB}$) est raccordé à un dispositif de précharge (PC) et à un circuit discriminateur (DISC), que le dispositif de précharge (PC) utilisé, dans le fonctionnement de test, pour précharger le couple externe de lignes de transmission de bits (XB,$\overline{XB}$) à deux niveaux logiques complémentaires l'un de l'autre, que le circuit discriminateur (DISC) délivre au niveau de sa sortie un signal d'erreur (FS), qui, lors du fonctionnement de test, identifie en tant qu'erreur un écart de niveau d'une ligne externe de transmission de bits (XB;$\overline{XB}$) du couple de lignes externes de transmission de bits (XB,$\overline{XB}$) par rapport au niveau logique, auquel elle est préchargée, et que dans le fonctionnement de test, pour la lecture de données à partir des cellules de mémoire (SZ) du bloc (B), tous les transistors de transfert (TT) reçoivent au niveau de leur grille un potentiel de transfert (Tpot).

2. Montage suivant la revendication 1, caractérisé par le fait que le potentiel de transfert (Tpot) est égal au potentiel d'alimentation (VCC) de l'ensemble du montage.

3. Montage suivant la revendication 1, caractérisé par le fait que le potentiel de tranfert (Tpot) est égal au moins à la moitié de la différence entre le potentiel d'alimentation (VCC) et le potentiel de référence (VSS) de l'ensemble du montage.

4. Montage suivant l'une des revendications précédentes, caractérisé par le fait que le dispositif de précharge (PC) comporte un circuit à bascule bistable de type RS (FF) qui possède deux sorties complémentaires l'une de l'autre (Q,$\overline{Q}$) et que les sorties (Q,$\overline{Q}$) sont raccordées par l'intermédiaire de transistors de précharge (PCT) au couple de lignes externes de transmission de bits (XB,$\overline{XB}$).

5. Montage suivant l'une des revendications précédentes, caractérisé par le fait que le circuit discriminateur (DISC) est un circuit inverseur CMOS, dont l'entrée peut être commutée entre les deux lignes externes de transmission de bits (XB,$\overline{XB}$).

6. Montage suivant la revendication 5, caractérisé par le fait que la largeur du canal du transistor à canal p du circuit inverseur CMOS est comprise entre 10 et 20 fois la largeur du canal du transistor à canal n, pour une même longueur supposée de canal.

7. Montage suivant l'une des revendications précédentes, caractérisé par le fait que le circuit discriminateur (DISC) peut être découplé électriquement du couple de lignes externes de transmission de bits (XB,$\overline{XB}$).

8. Procédé pour tester des cellules de mémoire (SZ) d'un bloc (B) d'une mémoire à semiconducteurs, qui sont disposés sous la forme d'une matrice et qui peuvent être commandés par l'intermédiaire de lignes de transmission de mots (WL ) et de lignes internes de transmission de bits (BL,$\overline{BL}$), les lignes internes de transmission de bits étant subdivisées respectivement en deux moitiés approximativement identiques par l'intermédiaire d'un circuit d'évaluation (BWS), la première moitié de chaque ligne interne de transmission de bits étant raccordée à une première ligne externe de transmission de bits d'un couple de lignes externes de transmission de bits, par l'intermédiaire d'un transistor de transfert (TT), tandis que la seconde moitié de chaque ligne interne de transmission de bits est raccordée à une seconde ligne externe de transmission de bits du couple de lignes externes de transmission de bits, également par l'intermédiaire d'un transistor de transfert, caractérisé par le fait que le test est exécuté simultanément au moyen des deux lignes externes de transmission de bits (XB,$\overline{XB}$) pour plus d'une et jusqu'à, au maximum, toutes les cellules de mémoire (SZ) raccordées à une ligne de transmission de mots (WL), moyennant l'utilisation d'un circuit discriminateur (DISC) raccordé au couple de lignes externes de transmission de bits (XB,$\overline{XB}$), que les lignes de transmission de bits du couple de lignes externes de transmission de bits (XB,$\overline{XB}$) sont préchargées à deux niveaux logiques complémentaires l'un de l'autre, qu'un potentiel de transfert (Tpot) est appliqué aux grilles des transistors de transfert (TT), que le circuit discriminateur (DISC) identifie en tant qu'erreur, lors de la lecture de données mémorisées dans les cellules de mémoire (SZ), un écart du niveau des lignes externes de transmission de bits (XB;$\overline{XB}$) du couple de lignes externes de transmission de bits (XB,$\overline{XB}$) et que lors de l'apparition d'une telle erreur à la sortie du circuit discriminateur (DISC), un signal d'erreur (FS) est déclenché.

9. Procédé suivant la revendication 8, caractérisé par le fait que lors du test, avant la lecture de données à partir de cellules de mémoire, les deux lignes externes de transmission de bits (XB,$\overline{XB}$) sont chargées à des niveaux logiques complémentaires l'un de l'autre, notamment au potentiel d'alimentation (VCC) et au potentiel de référence (VSS) du montage.

10. Procédé suivant la revendication 8 ou 9, caractérisé par le fait que le signal d'erreur (FS) est positionné lorsque le niveau de celle des deux lignes externes de transmission de bits (XB,$\overline{XB}$), qui est préchargée au niveau supérieur, de préférence au potentiel d'alimentation (VCC), tombe au moins à une valeur qui correspond à la valeur d'un potentiel de transfert (Tpot) diminuée d'une tension de seuil des transistors de transfert (TT).

# FIG 1

# FIG 2